# EUROPEAN PATENT APPLICATION

(11) **EP 4 783 381 A1**
(43) Date of publication of application: **29.07.2026**
(21) Application number: 24876134.8
(22) Date of filing: 03.07.2024
(51) Int. Cl.: H01S 5/40, H01S 5/06

(54) **LASER ARRAY AND LASER RADAR**

(30) Priority: 12.10.2023 CN 202311326329
(71) Applicant: HUAWEI TECHNOLOGIES CO., LTD., Shenzhen 518129 (CN)
(72) Inventor: HUANG, Zhihua, Shenzhen, Guangdong 518129 (CN); CHEN, Kaisheng, Shenzhen, Guangdong 518129 (CN)
(74) Representative: Goddar, Heinz J.
(86) International application number: PCT/CN2024/103304
(87) International publication number: WO 2025/077313

(57) **Abstract**

Embodiments of this application provide a laser array and a lidar, and relate to the field of optical sensing technologies. A differential resistance of the laser array is adjustable, and optical power of emitted laser light that is output is adjustable. The laser array includes a first laser and a second laser. The first laser includes a first reflection layer, a first active layer, and a second reflection layer that are sequentially disposed in an epitaxial direction. A first oxide aperture is provided in the second reflection layer. The second laser includes a third reflection layer, a second active layer, and a fourth reflection layer that are sequentially disposed in the epitaxial direction. A second oxide aperture is provided in the fourth reflection layer. A light blocking layer is further disposed on a side, away from the second active layer, of the fourth reflection layer. A projection of the light blocking layer on the second active layer overlaps a projection of the second oxide aperture on the second active layer. The first laser is electrically connected to the second laser.

## Description

This application claims priority to Chinese Patent Application No. 202311326329.2, filed with the China National Intellectual Property Administration on October 12, 2023 and entitled "LASER ARRAY AND LIDAR", which is incorporated herein by reference in its entirety.

### TECHNICAL FIELD

This application relates to the field of optical sensing technologies, and in particular, to a laser array and a lidar.

### BACKGROUND

Currently, automatic control devices develop rapidly, including a self-driving vehicle, a robotic vacuum cleaner, and the like. The automatic control devices specifically sense their surrounding environments through installed sensing systems them, and then perform next control actions based on the surrounding environments. A lidar (light detection and ranging, LIDAR) is a type of sensing system, configured to output emitted laser light. The emitted laser light is transmitted to an obstacle and then reflected to form the reflected laser light. The lidar receives the reflected laser light, and determines location information of the obstacle based on the emitted laser light and the reflected laser light.

An existing lidar usually includes a laser array that is specifically configured to output emitted laser light. The laser array includes one laser or more lasers connected in parallel. When the laser array includes a large quantity of lasers, a differential resistance of the laser array is small, and optical power of the emitted laser light output by the laser array is high but non-adjustable. In some other scenarios, the laser array needs to include only a small quantity of lasers and output emitted laser light with low optical power. As a quantity of lasers included in the laser array is reduced, a differential resistance of the laser array increases and is difficult to reduce.

### SUMMARY

Embodiments of this application provide a laser array and a lidar. A differential resistance of the laser array is adjustable, and optical power of emitted laser light that is output is adjustable.

According to a first aspect, a laser array is provided. The laser array includes a first laser and a second laser. The first laser includes a first reflection layer, a first active layer, and a second reflection layer that are sequentially disposed in an epitaxial direction. A first oxide aperture is provided in the second reflection layer. The second laser includes a third reflection layer, a second active layer, and a fourth reflection layer that are sequentially disposed in the epitaxial direction. A second oxide aperture is provided in the fourth reflection layer. A light blocking layer is further disposed on a side, away from the second active layer, of the fourth reflection layer. A projection of the light blocking layer on the second active layer overlaps a projection of the second oxide aperture on the second active layer. The first laser is electrically connected to the second laser. In the laser array, the first laser includes the first reflection layer, the first active layer, and the second reflection layer that are sequentially disposed in the epitaxial direction, and the first oxide aperture is provided in the second reflection layer. When the laser array receives a voltage or a current, the voltage or the current is transmitted to the first laser, to energize the first laser. Therefore, the first active layer of the first laser generates a first photon, and the first photon oscillates in a resonant cavity formed by the first reflection layer and the second reflection layer. In this way, first laser light is generated and is output through the first oxide aperture. The second laser includes the third reflection layer, the second active layer, and the fourth reflection layer that are sequentially disposed in the epitaxial direction, the second oxide aperture is provided in the fourth reflection layer, the light blocking layer is further disposed on the side, away from the second active layer, of the fourth reflection layer, and the projection of the light blocking layer on the second active layer overlaps the projection of the second oxide aperture on the second active layer. When the laser array receives a voltage or a current, the voltage or the current may be transmitted to the second laser, to energize the second laser. Therefore, the second active layer of the second laser generates a second photon, and the second photon oscillates in a resonant cavity formed by the third reflection layer and the fourth reflection layer, to generate second laser light. The second laser light is transmitted to the light blocking layer through the second oxide aperture. The light blocking layer blocks an output of the second laser light, or the light blocking layer outputs a part of the second laser light. Emitted laser light output by the laser array is specifically the first laser light and the second laser light. When the first laser is connected in parallel to the second laser and the laser array receives a constant voltage, a differential resistance of the first laser and the second laser that are connected in parallel is less than a differential resistance of the first laser. When the first laser is connected in parallel to the second laser and the laser array receives a constant current, optical power of the emitted laser light output by the laser array changes. When the first laser is connected in series to the second laser and the laser array receives a constant voltage, optical power of the emitted laser light output by the laser array changes. That is, when the laser array includes the second laser, a differential resistance of the laser array is adjustable, and the optical power of the emitted laser light that is output is adjustable.

Optionally, the laser array includes a plurality of first lasers and at least one second laser, the plurality of first lasers are connected in parallel, and at least one first laser is electrically connected to any second laser. In this optional manner, the laser array may specifically include M first lasers and N second lasers, where M is a positive integer greater than or equal to 2, and N is a positive integer greater than or equal to 1. In addition, the M first lasers are connected in parallel, the N second lasers are connected in parallel, and the first laser is connected in parallel to the second laser. It is assumed that differential resistances of the first laser and the second laser are approximately equal and are denoted as *Rₛ.* voltage, the differential resistance of the laser array is as follows: *R = Rₛ* / (*M + N*)*.* It can be learned that the differential resistance of the laser array decreases when a quantity of second lasers increases. The differential resistance of the laser array may be adjusted by adjusting the quantity of second lasers.

Optionally, the laser array includes one or more first areas, the first area includes the second laser, at least one first laser is connected in parallel to the second laser in the first area, second lasers in any two first areas are electrically isolated, and second lasers in any two first areas are connected in parallel. In this optional manner, it is assumed that the laser array includes M first lasers and X first areas, and one first area includes Y second lasers, where X is a positive integer greater than or equal to 1, and Y is a positive integer greater than or equal to 1. Because the at least one first laser is connected in parallel to the second laser in the first area, when the laser array receives a fixed voltage and all lasers are operating, optical power of laser light output by the plurality of first lasers does not change, and the differential resistance of the laser array is as follows: *R = Rₛ* /(*M + X* × *Y*)*.* It can be learned that the differential resistance of the laser array decreases when X increases and/or Y increases, and the differential resistance of the laser array increases when X decreases and/or Y decreases. When the laser array receives a fixed current *I*₀ and all the lasers are operating, because the plurality of first lasers are connected in parallel, the at least one first laser is connected in parallel to the second laser in the first area, and a plurality of second lasers are connected in parallel, a current flowing through the M first lasers is as follows: *I = M* × *I*₀ / (*M + X* × *Y*)*.* Based on a relationship between power and a current, it can be learned that Δ*P* = Δ*I* × *SE,* where *SE* is slope efficiency, Δ*I* is a variation of the current flowing through the M first lasers, and Δ*P* is a variation of optical power of laser light output by the M first lasers in parallel. It can be learned that, when X increases and/or Y increases, the current *I* flowing through the M first lasers decreases, and therefore the optical power of the laser light output by the M first lasers in the laser array decreases; and when X decreases and/or Y decreases, the current *I* flowing through the M first lasers increases, and therefore the optical power of the laser light output by the M first lasers in the laser array increases.

Optionally, the laser array includes one or more first areas, the first area includes the second laser, at least one first laser is connected in series to the second laser in the first area, second lasers in any two first areas are electrically isolated, and second lasers in any two first areas are connected in parallel. In this optional manner, it is assumed that the laser array includes M first lasers and X first areas, and one first area includes Y second lasers, where X is a positive integer greater than or equal to 1, and Y is a positive integer greater than or equal to 1. Differential resistances of the first laser and the second laser are approximately equal and are denoted as *Rₛ.* When the laser array receives a fixed current and all lasers are operating, because the first laser is connected in series to the second laser in the first area, the plurality of first lasers are connected in parallel, and second lasers in any two first areas are connected in parallel, optical power of laser light output by the first laser does not change, and the differential resistance of the laser array is as follows: *R = Rₛ* / *M + Rₛ* / (*X* × *Y*)*.* It can be learned that the differential resistance of the laser array decreases when X increases and/or Y increases, and the differential resistance of the laser array increases when X decreases and/or Y decreases. When the laser array receives a fixed voltage *V*₀ and all the lasers are operating, because the first laser is connected in series to the second laser in the first area, the plurality of first lasers are connected in parallel, and second lasers in any two first areas are connected in parallel, a voltage distributed to the M first lasers is as follows: *V =* (*X* × *Y*) × *V*₀ / (*M + X* × *Y*)*.* Based on a relationship between a voltage and a current, it can be learned that Δ*V* = Δ*I* * *Rₛ* / *M,* where Δ*V* is a variation of the voltage distributed to the M first lasers connected in parallel, and Δ*I* is a variation of a current flowing through the M first lasers. Through division between parts on the left of equal signs in Δ*V* = Δ*I *Rₛ* / *M* and Δ*P =* Δ*I* × *SE* and division between parts on the right of the equal signs, the following can be obtained: Δ*P = ΔV*×*SE*×*M*/*Rₛ.* lasers in the laser array increases when X increases and/or Y increases, and optical power of emitted laser light output by the M first lasers in the laser array decreases when X decreases and/or Y decreases.

Optionally, the laser array further includes a second area, the second area includes a plurality of first lasers, and the first laser in the second area is electrically isolated from a second laser in any first area.

Optionally, one or more second lasers are further disposed in the second area, and the first laser and the second laser in the second area are connected in parallel.

Optionally, the first area includes a plurality of second lasers, and the plurality of second lasers are connected in parallel.

Optionally, the laser array is configured to receive a fixed voltage.

Optionally, the laser array is configured to receive a fixed current.

Optionally, the first laser further includes: a first substrate disposed on a side, away from the first active layer, of the first reflection layer, a first negative electrode disposed on a side, away from the first active layer, of the first substrate, and a first positive electrode disposed on a side, away from the first active layer, of the second reflection layer; or the first laser further includes: a first substrate disposed on a side, away from the first active layer, of the first reflection layer, a first conducting layer disposed between the first substrate and the first reflection layer, a first negative electrode in contact with the first conducting layer, and a first positive electrode disposed on a side, away from the first active layer, of the second reflection layer.

Optionally, the second laser further includes: a second substrate disposed on a side, away from the second active layer, of the third reflection layer, a second negative electrode disposed on a side, away from the second active layer, of the second substrate, and a second positive electrode disposed on a side, away from the second active layer, of the fourth reflection layer; or the second laser further includes: a second substrate disposed on a side, away from the second active layer, of the third reflection layer, a second conducting layer disposed between the second substrate and the third reflection layer, a second negative electrode in contact with the second conducting layer, and a second positive electrode disposed on a side, away from the second active layer, of the fourth reflection layer.

According to a second aspect, a lidar is provided, including a driving apparatus and the laser array according to any one of the implementations of the first aspect. The driving apparatus is configured to input a fixed voltage or a fixed current to the laser array.

Optionally, the laser array includes one or more first areas. The driving apparatus is configured to receive an input signal, and control, based on the input signal, an input of the fixed voltage or the fixed current to n first areas, where the input signal is an input signal received by the lidar, and n is an integer greater than or equal to 0.

Optionally, the laser array includes one or more first areas. The driving apparatus is configured to receive a feedback signal, and control, based on the feedback signal, an input of the fixed voltage or the fixed current to n first areas, where n is an integer greater than or equal to 0.

Optionally, the lidar further includes a receiving apparatus and a signal processing apparatus. The receiving apparatus is configured to receive reflected laser light, generate a received signal, and transmit the received signal to the signal processing apparatus, where emitted laser light is reflected to form the reflected laser light when encountering an obstacle. The signal processing apparatus is configured to generate the feedback signal based on the received signal.

Optionally, the signal processing apparatus is further configured to determine a distance between the obstacle and the lidar based on the received signal.

For technical effects of any possible implementation of the second aspect, refer to the technical effects of different implementations of the first aspect. Details are not described herein again.

### BRIEF DESCRIPTION OF DRAWINGS

FIG. 1 is a diagram of a structure of a lidar according to an embodiment of this application;
FIG. 2 is a diagram of a structure of a laser array according to an embodiment of this application;
FIG. 3 is a diagram in which optical power of reflected laser light received by a receiving apparatus varies with a distance between an obstacle and a lidar according to an embodiment of this application;
FIG. 4 is a diagram of a structure of a laser array according to another embodiment of this application;
FIG. 5 is a diagram of electrical driving pulses for driving different quantities of vertical-cavity surface-emitting lasers to output emitted laser light according to an embodiment of this application;
FIG. 6A to FIG. 6C are diagrams of a structure of a laser array according to still another embodiment of this application;
FIG. 7 is a diagram of a structure of a first laser in a laser array according to yet another embodiment of this application;
FIG. 8 is a diagram of a structure of a second laser in a laser array according to still yet another embodiment of this application;
FIG. 9 is a diagram of a structure of a laser array according to a further embodiment of this application;
FIG. 10 is a cross-sectional view 1 of FIG. 9 along AA';
FIG. 11 is a cross-sectional view 2 of FIG. 9 along AA';
FIG. 12 is a diagram of a structure of a laser array according to a still further embodiment of this application;
FIG. 13 is a cross-sectional view of FIG. 12 along BB';
FIG. 14 is a cross-sectional view 1 of FIG. 12 along CC';
FIG. 15 is a diagram of a structure of a laser array according to a yet further embodiment of this application;
FIG. 16 is a diagram of a structure of a laser array according to a still yet further embodiment of this application;
FIG. 17 is a cross-sectional view of FIG. 16 along DD';
FIG. 18 is a cross-sectional view 1 of FIG. 16 along EE'; and
FIG. 19 is a diagram of a structure of a laser array according to an even yet another embodiment of this application.

### DESCRIPTION OF EMBODIMENTS

The following describes the technical solutions in embodiments of this application with reference to the accompanying drawings in embodiments of this application. Clearly, the described embodiments are merely some but not all of embodiments of this application.

Unless otherwise defined, all technical terms used in this specification have the same meanings as those commonly known to a person of ordinary skill in the art. In embodiments of this application, "at least one" means one or more, and "a plurality of" means two or more. "And/or" describes an association relationship between associated objects, and indicates that three relationships may exist. For example, A and/or B may indicate the following three cases: Only A exists, both A and B exist, and only B exists, where A and B may be in a singular form or a plural form. The character "/" usually indicates an "or" relationship between the associated objects. "At least one of the following items (pieces)" or a similar expression thereof indicates any combination of the items, including one of the items (pieces) or any combination of a plurality of the items (pieces). For example, at least one of a, b, or c may indicate a, b, c, "a and b", "a and c", "b and c", or "a, b and c", where a, b, and c may be in a singular form or a plural form. In addition, in embodiments of this application, the terms "first", "second", and the like do not limit a quantity or an execution sequence.

In addition, in embodiments of this application, orientation terms such as "above" and "below" are defined relative to placement orientations of components shown in the accompanying drawings. It should be understood that these directional terms are relative concepts that are used for relative description and clarification, and may vary correspondingly based on changes in the placement orientations of the components in the accompanying drawings.

In embodiments of this application, the term "in an example", "for example", or the like is used to give an example, an illustration, or a description. Any embodiment or design scheme described with "in an example" or "for example" in embodiments of this application should not be construed as being more preferred or advantageous than another embodiment or design scheme. To be precise, the term "in an example", "for example", or the like is intended to present a related concept in a specific manner.

The following describes the technical solutions in embodiments of this application with reference to the accompanying drawings in embodiments of this application. Clearly, the described embodiments are merely some but not all of embodiments of this application.

Currently, automatic control devices develop rapidly. The automatic control devices include a self-driving vehicle, a robotic vacuum cleaner, and the like. The automatic control devices specifically sense surrounding environments of the automatic control devices through sensing systems installed on the automatic control devices, and then perform next control actions based on the surrounding environments. A lidar (light detection and ranging, LIDAR) is a type of sensing system.

For example, the lidar may be mounted in a self-driving vehicle as a vehicle-mounted lidar or an airborne lidar. The lidar is configured to detect a distance between the self-driving vehicle and an object (an obstacle) around the self-driving vehicle. The self-driving vehicle performs a control action, for example, emergency braking or turning, based on the distance detected by the lidar.

In addition, the lidar may alternatively be mounted in a robotic vacuum cleaner. The lidar is configured to detect a distance between the robotic vacuum cleaner and furniture (an obstacle) around the robotic vacuum cleaner. The robotic vacuum cleaner performs a control action, for example, steering or deceleration, based on the distance detected by the lidar.

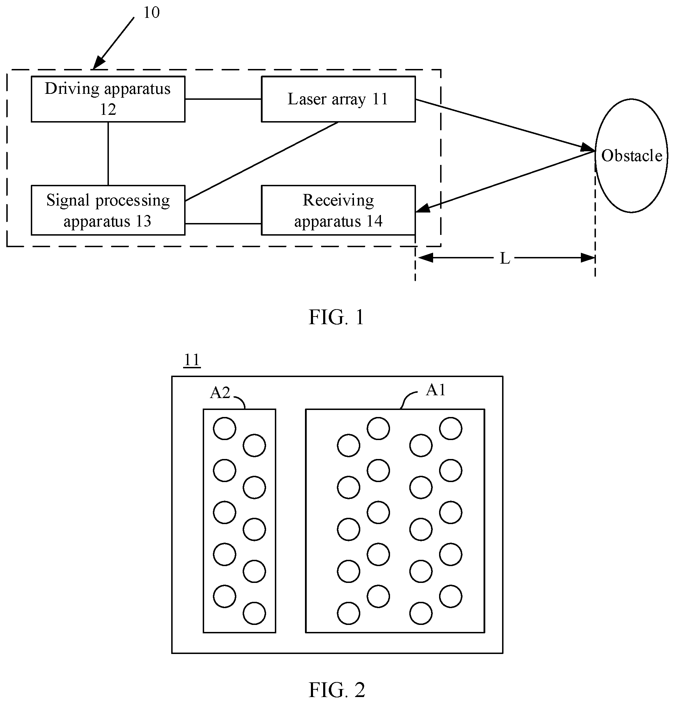

As shown in FIG. 1, an embodiment of this application provides a diagram of a structure of a lidar 10. The lidar 10 includes a laser array 11 and a driving apparatus 12. The driving apparatus 12 is configured to drive the laser array 11 to output emitted laser light. The emitted laser light is transmitted to an obstacle. The obstacle may be any object around the lidar 10. After being transmitted to a surface of the obstacle, the emitted laser light is reflected to form reflected laser light. The lidar 10 receives the reflected laser light, and determines a distance L between the lidar 10 and the obstacle based on the emitted laser light and the reflected laser light.

For example, the lidar 10 shown in FIG. 1 further includes a signal processing apparatus 13 and a receiving apparatus 14. Specifically, the receiving apparatus 14 receives the reflected laser light, generates a received signal based on the reflected laser light, and transmits the received signal to the signal processing apparatus 13. The signal processing apparatus 13 is configured to determine the distance L between the lidar 10 and the obstacle based on the received signal. The signal processing apparatus 13 may determine the distance L between the lidar 10 and the obstacle according to a pulse-based time-of-flight (time-of-flight, TOF) principle, or determine the distance L between the lidar 10 and the obstacle according to a coherent frequency modulated continuous wave (frequency modulated continuous wave, FMCW) principle.

For example, when the signal processing apparatus 13 determines the distance between the lidar 10 and the obstacle according to the TOF principle, the signal processing apparatus 13 receives time at which the laser array 11 outputs the emitted laser light, and the received signal transmitted by the receiving apparatus 14 to the signal processing apparatus 13 includes time at which the receiving apparatus 14 receives the reflected laser light. Because a speed of light is fixed and known, the signal processing apparatus 13 may determine the distance L between the lidar 10 and the obstacle based on a difference between the time at which the emitted laser light is output and the time at which the reflected laser light is received.

For example, the driving apparatus 12 usually drives the laser array 11 to continuously output a plurality of beams of emitted laser light. For example, two adjacent beams of emitted laser light among the plurality of beams of emitted laser light output by the laser array 11 are emitted laser light s1 and emitted laser light s2. The laser array 11 outputs the emitted laser light s1 at a first moment, and the receiving apparatus 14 receives reflected laser light s1' that is formed after the emitted laser light s1 is transmitted to the obstacle and then reflected. Then the laser array 11 outputs the emitted laser light s2 at a second moment later than the first moment, and the receiving apparatus 14 receives reflected laser light s2' that is formed after the emitted laser light s2 is transmitted to the obstacle and then reflected; and so on. After the laser array 11 continuously outputs several to tens of thousands of beams of emitted laser light in a same direction within one second, the receiving apparatus 14 receives several to tens of thousands of beams of reflected laser light. In this way, the lidar 10 can determine distances between the obstacle and the lidar 10 at different moments, and then determine a speed parameter of the obstacle. For example, after the laser array 11 continuously outputs several to tens of thousands of emitted beams in different directions within one second, the receiving apparatus 14 receives several to tens of thousands of beams of reflected laser light. In this way, the lidar 10 can determine distances between different positions on the obstacle and the lidar 10, and then determine a physical model of the obstacle.

For example, an existing laser array 11 usually includes a vertical-cavity surface-emitting laser (vertical-cavity surface-emitting laser, VCSEL). Compared with an edge-emitting laser (edge-emitting laser, EEL), the vertical-cavity surface-emitting laser has the following advantages: low costs, a small divergence angle of emitted laser light that is output, a low threshold current, a simple packaging process, and ease of implementation of a two-dimensional integrated surface light source. However, optical power of emitted laser light output by one vertical-cavity surface-emitting laser is limited. Therefore, in the existing laser array 11, a plurality of vertical-cavity surface-emitting lasers are usually connected in parallel, to increase optical power of emitted laser light output by the laser array 11.

When a quantity of vertical-cavity surface-emitting lasers included in the laser array 11 is determined and a voltage or a current received by the laser array 11 remains unchanged, the optical power of the emitted laser light output by the laser array 11 is also fixed, and the optical power of the emitted laser light output by the laser array 11 is non-adjustable. When the distance between the obstacle and the lidar 10 is long, the laser array 11 needs to output emitted laser light with high optical power, so that optical power of the reflected laser light received by the receiving apparatus 14 is not less than minimum optical power that the receiving apparatus 14 can receive, and the receiving apparatus 14 can generate the received signal based on the reflected laser light. When the distance between the obstacle and the lidar 10 is short, if optical power of the emitted laser light output by the laser array 11 is still quite high, optical power of the reflected laser light received by the receiving apparatus 14 may be greater than maximum optical power that the receiving apparatus 14 can receive. Consequently, the reflected laser light received by the receiving apparatus 14 is saturated, leading to distortion of the received signal generated by the receiving apparatus 14.

For example, to make the optical power of the emitted laser light output by the laser array 11 changeable, the existing laser array 10 usually includes two different partitions. One partition outputs emitted laser light with high optical power, and the other partition outputs emitted laser light with low optical power. For example, FIG. 2 is a diagram of a structure of a laser array 11 according to an embodiment of this application. The laser array 11 includes a partition A1 and a partition A2. The partition A1 includes 20 vertical-cavity surface-emitting lasers connected in parallel. The partition A2 includes 10 vertical-cavity surface-emitting lasers connected in parallel. The vertical-cavity surface-emitting lasers in the partition A2 are electrically isolated from the vertical-cavity surface-emitting lasers in the partition A1. When the distance between the obstacle and the lidar 10 is long, the 20 vertical-cavity surface-emitting lasers connected in parallel in the partition A1 are selected to output emitted laser light with high optical power. When the distance between the obstacle and the lidar 10 is short, the 10 vertical-cavity surface-emitting lasers connected in parallel in the partition A2 are selected to output emitted laser light with low optical power.

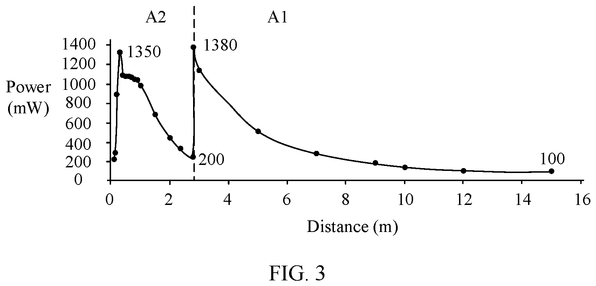

FIG. 3 is a diagram in which optical power of reflected laser light received by a receiving apparatus 14 varies with a distance between an obstacle and a lidar 10 according to an embodiment of this application. A horizontal coordinate in FIG. 3 represents the distance between the obstacle and the lidar 10, in units of meters (m). A vertical coordinate in FIG. 3 represents the optical power of the reflected laser light received by the receiving apparatus 14, in units of milliwatts (mW). In FIG. 3, maximum optical power that the receiving apparatus 14 can receive is 1400 mW, and minimum optical power that the receiving apparatus 14 can receive is 80 mW. As shown in FIG. 3, when the distance between the obstacle and the lidar 10 is less than 3 m, the 10 vertical-cavity surface-emitting lasers connected in parallel in the partition A2 are selected to output emitted laser light. In this case, the optical power of the reflected laser light received by the receiving apparatus 14 decreases with an increase in the distance between the obstacle and the lidar 10, maximum optical power of the reflected laser light received by the receiving apparatus 14 is 1350 mW, and minimum optical power of the reflected laser light received by the receiving apparatus 14 is 200 mW. When the distance between the obstacle and the lidar 10 is greater than or equal to 3 m, the 20 vertical-cavity surface-emitting lasers connected in parallel in the partition A1 are selected to output emitted laser light. In this case, the optical power of the reflected laser light received by the receiving apparatus 14 decreases with an increase in the distance between the obstacle and the lidar 10, maximum optical power of the reflected laser light received by the receiving apparatus 14 is 1380 mW, and minimum optical power of the reflected laser light received by the receiving apparatus 14 is 100 mW.

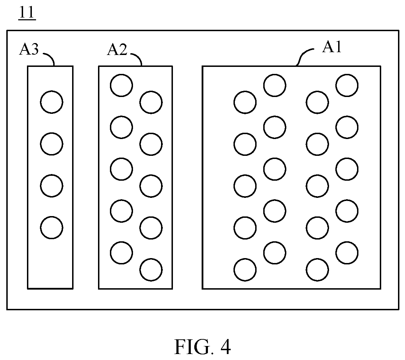

In some embodiments, refer to FIG. 4. Compared with the laser array 11 shown in FIG. 2, a laser array 11 shown in FIG. 4 further includes a partition A3, and the partition A3 includes four vertical-cavity surface-emitting lasers connected in parallel. When the distance between the obstacle and the lidar 10 is greater than or equal to 4 m, the 20 vertical-cavity surface-emitting lasers connected in parallel in the partition A1 are selected to output emitted laser light. When the distance between the obstacle and the lidar 10 is greater than or equal to 1 m and less than 4 m, the 10 vertical-cavity surface-emitting lasers connected in parallel in the partition A2 are selected to output emitted laser light. When the distance between the obstacle and the lidar 10 is less than 1 m, the four vertical-cavity surface-emitting lasers connected in parallel in the partition A3 are selected to output emitted laser light.

For example, the laser array 11 may include more partitions, and a quantity of vertical-cavity surface-emitting lasers included in each partition may be changed, so that the laser array 11 selects, based on the distance between the obstacle and the lidar 10, a vertical-cavity surface-emitting laser in any partition to output emitted laser light with predetermined optical power.

However, in the laser array 11 shown in FIG. 2 or FIG. 4, different partitions are at different locations. When the laser array 11 needs to emit laser light to a predetermined location, optical systems with different parameters need to be used to transmit laser light emitted by different partitions to the predetermined location. Consequently, the laser array 11 has a redundant and complex design.

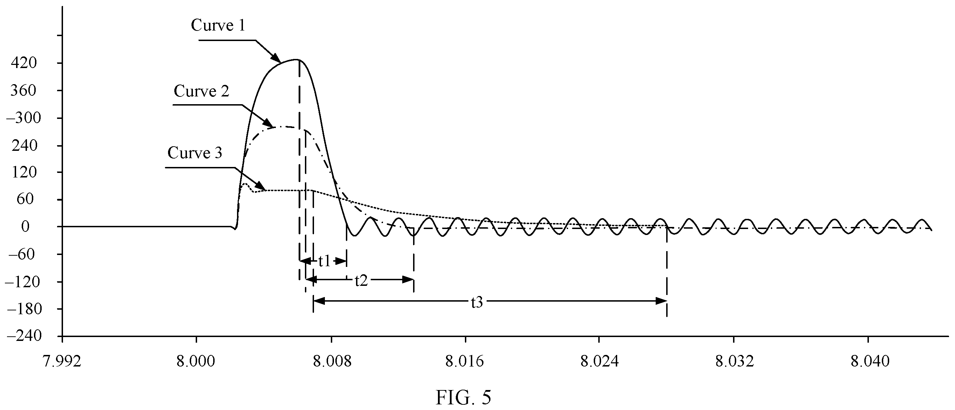

Particularly, in a solution of a partitioned design, for a partition that includes a small quantity of vertical-cavity surface-emitting lasers, a decrease in a quantity of vertical-cavity surface-emitting lasers leads to an increase in a differential resistance of the partition. When the differential resistance of the partition increases, falling time of an electrical driving pulse for driving the vertical-cavity surface-emitting lasers in the partition to output emitted laser light becomes longer, and a cycle of the electrical driving pulse becomes longer. Consequently, a cycle of outputting a plurality of beams of pulsed laser light by the partition becomes longer, affecting a detection rate of the lidar. Specifically, FIG. 5 is a diagram of electrical driving pulses for driving different quantities of vertical-cavity surface-emitting lasers to output emitted laser light according to an embodiment of this application. A horizontal coordinate in FIG. 5 represents time, in units of microseconds (µs). A vertical coordinate in FIG. 5 represents a current value of an electrical driving pulse, in units of milliamperes (mA). As shown in FIG. 5, a curve 1 represents an electrical driving pulse for driving 14 vertical-cavity surface-emitting lasers to output emitted laser light in parallel. In the curve 1, falling time of the electrical driving pulse (time from a moment at which a falling edge of the electrical driving pulse occurs to a moment at which a current of the electrical driving pulse decreases to 0 mA) is t1. A curve 2 represents an electrical driving pulse for driving nine vertical-cavity surface-emitting lasers to output emitted laser light in parallel. In the curve 2, falling time of the electrical driving pulse is t2. A curve 3 represents an electrical driving pulse for driving two vertical-cavity surface-emitting lasers to output emitted laser light in parallel. In the curve 3, falling time of the electrical driving pulse is t3. It can be learned from FIG. 5 that t3>t2>t1. When vertical-cavity surface-emitting lasers are driven to output two beams of emitted laser light, a second electrical driving pulse needs to appear after a current of a previous electrical driving pulse decreases to 0 mA. Therefore, it can be learned from FIG. 5 that, when a quantity of vertical-cavity surface-emitting lasers included in an area decreases, a differential resistance of the area increases, falling time of an electrical driving pulse for driving the vertical-cavity surface-emitting lasers in the area to output emitted laser light becomes longer, and a cycle of the electrical driving pulse becomes longer. Consequently, a cycle of outputting a plurality of beams of emitted laser light by the vertical-cavity surface-emitting lasers in the area is long, affecting a detection rate of the lidar.

In view of this, embodiments of this application provide a laser array. A differential resistance of the laser array is adjustable, and optical power of emitted laser light that is output is adjustable.

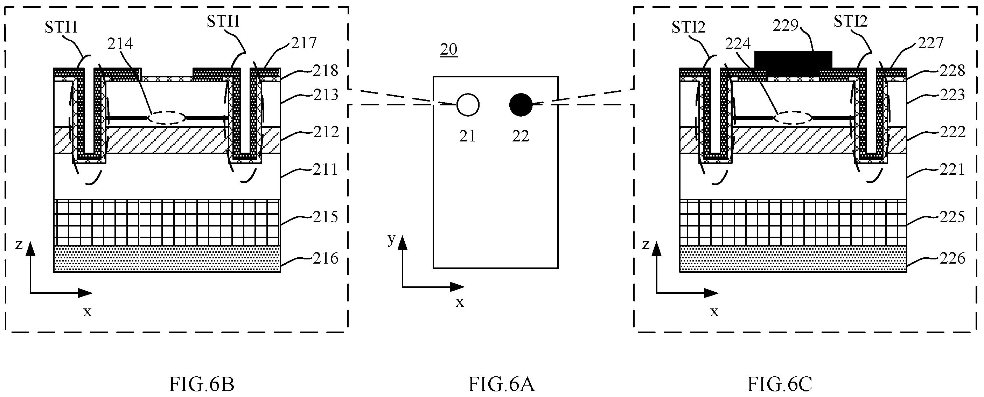

FIG. 6A to FIG. 6C are diagrams of a structure of a laser array 20 according to an embodiment of this application. FIG. 6A is a top view of the laser array 20. The laser array 20 includes a laser 21 (also referred to as a first laser) and a laser 22 (also referred to as a second laser).

FIG. 6B is a cross-sectional view of the laser 21 in the laser array 20. The laser 21 includes a reflection layer 211 (also referred to as a first reflection layer), an active layer 212 (also referred to as a first active layer), and a reflection layer 213 (also referred to as a second reflection layer) that are sequentially disposed in an epitaxial direction (a z-axis direction in FIG. 6A to FIG. 6C). An oxide aperture 214 (also referred to as a first oxide aperture) is provided in the reflection layer 213.

For example, the laser 21 is also referred to as a semiconductor laser, and is specifically a vertical-cavity surface-emitting laser. The reflection layer 211 and the reflection layer 213 form a resonant cavity of the laser 21, and the active layer 212 forms a pump source of the laser 21. When the laser 21 is energized (receives a current or a voltage), the active layer 212 generates photons, and the photons repeatedly oscillate in the resonant cavity formed by the reflection layer 211 and the reflection layer 213. The resonant cavity selects photons with a specified frequency and consistent directions for amplification at a top priority, and suppresses photons with other frequencies and directions, to generate laser light, and the laser light is output through the oxide aperture 214. For example, after the active layer 212 generates the photons, all photons that do not move along an axis (the z-axis direction) of the resonant cavity quickly escape from the resonant cavity and are no longer in contact with the active layer 212; and all photons that move along the axis of the resonant cavity continue to move forward in the cavity, and continuously move back and forth to pass the active layer 212 through reflection by the reflection layer 211 and the reflection layer 213 to generate stimulated radiation, to form a strong beam, namely, laser light, with a consistent propagation direction, a same frequency, and a same phase in the resonant cavity, and the laser light is output through the oxide aperture 214 in the reflection layer 213. The oxide aperture 214 may limit a transverse mode of laser light output by the laser 21 and transverse distribution of current density, and a size of the oxide aperture 214 determines whether the laser 21 is in a multi-transverse-mode state or a single-transverse-mode state. For example, the transverse distribution of the current density is specifically current density of a current within a range of the oxide aperture 214. When the size of the oxide aperture 214 is small and the laser 21 receives a small current or voltage, current density may reach a threshold condition for generating a photon by the active layer 212. That is, a threshold current or a threshold voltage of the laser 21 is small. A differential resistance of the laser 21 is negatively correlated with the size of the oxide aperture 214. Therefore, when the size of the oxide aperture 214 is small, the differential resistance of the laser 21 is large and cannot be ignored. The threshold current or the threshold voltage of the laser 21 needs to be small. A reason lies in: When a current received by the laser 21 is less than the threshold current or a voltage received by the laser 21 is less than the threshold voltage, the laser 21 converts the received current or voltage into joule heat. When the threshold current or the threshold voltage of the laser 21 is large, the joule heat generated through conversion by the laser 21 is large, and the large joule heat affects performance of the laser 21.

As shown in FIG. 6B, the reflection layer 211 and the reflection layer 213 are made of a semiconductor material with a high reflectivity (for example, the reflectivity is 99.9%). In some embodiments, the reflection layer 211 is formed through alternate epitaxial growth of a semiconductor material with a high refractive index and a semiconductor material with a low refractive index, and the reflection layer 213 is formed through alternate epitaxial growth of a semiconductor material with a high refractive index and a semiconductor material with a low refractive index. The reflection layer 213 may provide electron holes, and the reflection layer 211 may provide electrons; or the reflection layer 213 may provide electrons, and the reflection layer 211 may provide electron holes. The reflection layer 211 and the reflection layer 213 are configured to provide electrons and electron holes (collectively referred to as carriers) respectively. The active layer 212 may be made of a semiconductor material with a high optical gain, and the semiconductor material may be a quantum well (quantum well, QW). In this way, under excitation of a current or a voltage, carriers (for example, electrons and electron holes) are combined at the active layer 212 to form photons, and the photons are emitted.

As shown in FIG. 6B, the laser 21 further includes a substrate 215 (also referred to as a first substrate) disposed on a side, away from the active layer 212, of the reflection layer 211. A projection of the active layer 212 on the substrate 215 is within a range of a projection of the reflection layer 211 on the substrate 215. For example, the active layer 212 and the reflection layer 211 have a same size and shape, or the active layer 212 has a smaller size than the reflection layer 211. Specifically, the reflection layer 211 may be in a square shape, the active layer 212 may be in a circular shape, and the two layers have a same central axis; or both the reflection layer 211 and the active layer 212 are in a square shape, and have a completely same size and shape. Similarly, a projection of the reflection layer 213 on the substrate 215 is within the range of the projection of the reflection layer 211 on the substrate 215.

In an embodiment, as shown in FIG. 6B, the laser 21 further includes a negative electrode 216 (also referred to as a first negative electrode) disposed on a side, away from the active layer 212, of the substrate 215, and a positive electrode 217 (also referred to as a first positive electrode) disposed on a side, away from the active layer 212, of the reflection layer 213. Energization of the laser 21 is specifically as follows: The negative electrode 216 and the positive electrode 217 of the laser 21 receive a voltage or a current to form a voltage difference, so that the active layer 212 generates photons. A projection of the positive electrode 217 on the substrate 215 does not overlap a projection of the oxide aperture 214 on the substrate 215, and the substrate 215 is specifically a conductive substrate. In some embodiments, the oxide aperture 214 is specifically prepared in the following manner: An annular shallow trench isolation (shallow trench isolation, STI) STI1 is formed, and an oxide grows inward from an inner wall of the annular STI1, to form the oxide aperture 214 with a predetermined size. The STI1 may be in a circular ring shape, so that the oxide aperture is in a circular shape. Alternatively, the STI1 may be in a polygonal ring shape, so that the oxide aperture is in a polygonal shape. In the z-axis direction, the STI1 passes through the reflection layer 213 and the active layer 212 and is in contact with the reflection layer 211. Usually, after the STI1 is formed in the laser 21 and the oxide aperture 214 is prepared, an insulation material is deposited in the STI1 and on the reflection layer 213 to form an insulation layer 218. Then a pattern of the positive electrode 217 is prepared at the insulation layer 218 through photoengraving and etching processes, and then the positive electrode 217 is prepared. The insulation layer 218 exists between the positive electrode 217 and the STI1, and the positive electrode 217 is in contact with the reflection layer 213. In addition, a part of the insulation layer 218 further exists in an area surrounded by the positive electrode 217, and a projection of this part of the insulation layer 218 on the active layer 212 covers a projection of the oxide aperture 214 on the active layer 212.

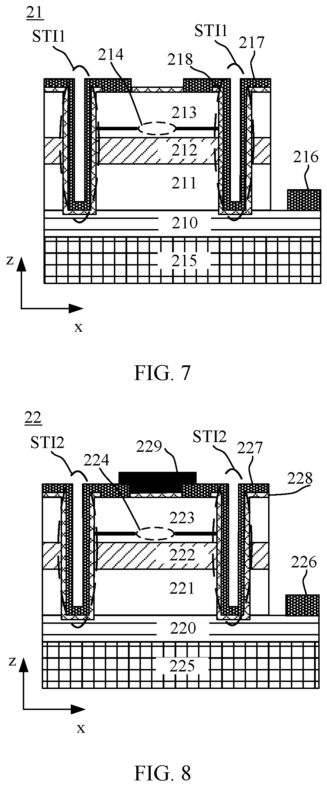

In another embodiment, as shown in FIG. 7, the laser 21 further includes a conducting layer 210 (also referred to as a first conducting layer) disposed between the substrate 215 and the reflection layer 211, a negative electrode 216 in contact with the conducting layer 210, and a positive electrode 217 disposed on a side, away from the active layer 212, of the reflection layer 213. Energization of the laser 21 is specifically as follows: The negative electrode 216 and the positive electrode 217 of the laser 21 receive a voltage or a current to form a voltage difference, so that the active layer 212 generates photons. A projection of the positive electrode 217 on the substrate 215 does not overlap a projection of the oxide aperture 214 on the substrate 215, and the substrate 215 is specifically an insulation substrate. In some embodiments, the oxide aperture 214 is specifically prepared in the following manner: An annular shallow trench isolation (shallow trench isolation, STI) STI1 is formed, and an oxide grows inward from an inner wall of the annular STI1, to form the oxide aperture 214 with a predetermined size. The STI1 may be in a circular ring shape, so that the oxide aperture is in a circular shape. Alternatively, the STI1 may be in a polygonal ring shape, so that the oxide aperture is in a polygonal shape. In the z-axis direction, the STI1 passes through the reflection layer 213 and the active layer 212 and is in contact with the reflection layer 211 (this is the same as the case of the STI1 shown in FIG. 6B). In some examples, the STI1 further passes through the reflection layer 211 and is in contact with the conducting layer 210. Usually, after the STI1 is formed in the laser 21 and the oxide aperture 214 is prepared, an insulation material is deposited in the STI1 and on the reflection layer 213 to form an insulation layer 218. Then a pattern of the positive electrode 217 is prepared at the insulation layer 218 through photoengraving and etching processes, and then the positive electrode 217 is prepared. The insulation layer 218 exists between the positive electrode 217 and the STI1, and the positive electrode 217 is in contact with the reflection layer 213. In addition, a part of the insulation layer 218 further exists in an area surrounded by the positive electrode 217, and a projection of this part of the insulation layer 218 on the active layer 212 covers a projection of the oxide aperture 214 on the active layer 212.

For example, as shown in FIG. 7, regardless of whether the STI1 passes through the reflection layer 213 and the active layer 212 or the STI1 passes through the reflection layer 213, the active layer 212, and the reflection layer 211, the negative electrode 216 in FIG. 7 may or may not be in contact with the reflection layer 211. For example, an insulation layer may be disposed between the reflection layer 211 and the negative electrode 216, so that the negative electrode 216 is not in contact with the reflection layer 211; or a predetermined spacing is controlled between the reflection layer 211 and the negative electrode 216 in an x-axis direction, so that the negative electrode 216 is not in contact with the reflection layer 211.

FIG. 6C is a cross-sectional view of the laser 22 in the laser array 20. The laser 22 includes a reflection layer 221 (also referred to as a third reflection layer), an active layer 222 (also referred to as a second active layer), and a reflection layer 223 (also referred to as a fourth reflection layer) that are sequentially disposed in the epitaxial direction (the z-axis direction in FIG. 6A to FIG. 6C). An oxide aperture 224 (also referred to as a second oxide aperture) is provided in the reflection layer 223. A light blocking layer 229 is further disposed on a side, away from the active layer 222, of the reflection layer 223. A projection of the light blocking layer 229 on the active layer 222 overlaps a projection of the oxide aperture 224 on the active layer 222.

For example, the laser 22 is also referred to as a semiconductor laser, and is specifically a vertical-cavity surface-emitting laser. The reflection layer 221 and the reflection layer 223 form a resonant cavity of the laser 22, and the active layer 222 forms a pump source of the laser 22. When the laser 22 is energized (receives a current or a voltage), the active layer 222 generates photons, and the photons repeatedly oscillate in the resonant cavity formed by the reflection layer 221 and the reflection layer 223. The resonant cavity selects photons with a specified frequency and consistent directions for amplification at a top priority, and suppresses photons with other frequencies and directions, to generate laser light, and the laser light is transmitted to the light blocking layer 229 through the oxide aperture 224.

As shown in FIG. 6C, that the projection of the light blocking layer 229 on the active layer 222 overlaps the projection of the oxide aperture 224 on the active layer 222 may be that the projection of the light blocking layer 229 on the active layer 222 completely covers the projection of the oxide aperture 224 on the active layer 222, so that laser light generated by the laser 22 is blocked by the light blocking layer 229, and the laser 22 does not output the laser light; or may be that the projection of the light blocking layer 229 on the active layer 222 covers a part of the projection of the oxide aperture 224 on the active layer 222, so that a part of laser light output by the laser 22 is blocked by the light blocking layer 229. When the laser 22 and the laser 21 receive a same voltage, optical power of laser light output by the laser 22 is less than optical power of laser light output by the laser 22.

For example, for a structure and a function of the reflection layer 221, refer to the structure and the function of the reflection layer 211; for a structure and a function of the active layer 222, refer to the structure and the function of the active layer 222; and for a structure and a function of the reflection layer 223, refer to the structure and the function of the reflection layer 213. Details are not described herein again.

As shown in FIG. 6C, the laser 22 further includes a substrate 225 (also referred to as a second substrate) disposed on a side, away from the active layer 222, of the reflection layer 221. A projection of the active layer 222 on the substrate 225 is within a range of a projection of the reflection layer 221 on the substrate 225. For example, the active layer 222 and the reflection layer 221 have a same size and shape, or the active layer 222 has a smaller size than the reflection layer 221. Specifically, the reflection layer 221 may be in a square shape, the active layer 222 may be in a circular shape, and the two layers have a same central axis; or both the reflection layer 221 and the active layer 222 are in a square shape, and have a completely same size and shape. Similarly, a projection of the reflection layer 223 on the substrate 225 is within the range of the projection of the reflection layer 221 on the substrate 215.

In an embodiment, as shown in FIG. 6C, the laser 22 further includes a negative electrode 226 (also referred to as a second negative electrode) disposed on a side, away from the active layer 222, of the substrate 225, and a positive electrode 227 (also referred to as a second positive electrode) disposed on a side, away from the active layer 222, of the reflection layer 223. Energization of the laser 22 is specifically as follows: The negative electrode 226 and the positive electrode 227 of the laser 22 receive a voltage or a current to form a voltage difference, so that the active layer 222 generates photons. A projection of the positive electrode 227 on the substrate 225 does not overlap a projection of the oxide aperture 224 on the substrate 225, and the substrate 225 is specifically a conductive substrate. In some embodiments, the oxide aperture 224 is specifically prepared in the following manner: An annular STI2 is formed, and an oxide grows inward from an inner wall of the annular STI2, to form the oxide aperture 224 with a predetermined size. The STI2 may be in a circular ring shape, so that the oxide aperture is in a circular shape. Alternatively, the STI2 may be in a polygonal ring shape, so that the oxide aperture is in a polygonal shape. In the z-axis direction, the STI2 passes through the reflection layer 223 and the active layer 222 and is in contact with the reflection layer 221. Usually, after the STI2 is formed in the laser 22 and the oxide aperture 224 is prepared, an insulation material is deposited in the STI2 and on the reflection layer 223 to form an insulation layer 228. Then a pattern of the positive electrode 227 is prepared at the insulation layer 228 through photoengraving and etching processes, and then the positive electrode 227 is prepared. The insulation layer 228 exists between the positive electrode 227 and the STI2, and the positive electrode 227 is in contact with the reflection layer 223. In addition, a part of the insulation layer 228 further exists in an area surrounded by the positive electrode 227, and a projection of this part of the insulation layer 228 on the active layer 222 covers a projection of the oxide aperture 224 on the active layer 222.

In another embodiment, as shown in FIG. 8, the laser 22 further includes a conducting layer 220 (also referred to as a second conducting layer) disposed between the substrate 225 and the reflection layer 221, a negative electrode 226 in contact with the conducting layer 220, and a positive electrode 227 disposed on a side, away from the active layer 222, of the reflection layer 223. Energization of the laser 22 is specifically as follows: The negative electrode 226 and the positive electrode 227 of the laser 22 receive a voltage or a current to form a voltage difference, so that the active layer 222 generates photons. A projection of the positive electrode 227 on the substrate 225 does not overlap a projection of the oxide aperture 224 on the substrate 225, and the substrate 225 is specifically an insulation substrate. In some embodiments, the oxide aperture 224 is specifically prepared in the following manner: An annular shallow trench isolation (shallow trench isolation, STI) STI2 is formed, and an oxide grows inward from an inner wall of the annular STI2, to form the oxide aperture 224 with a predetermined size. The STI2 may be in a circular ring shape, so that the oxide aperture is in a circular shape. Alternatively, the STI2 may be in a polygonal ring shape, so that the oxide aperture is in a polygonal shape. In the z-axis direction, the STI2 passes through the reflection layer 223 and the active layer 222 and is in contact with the reflection layer 221 (this is the same as the case of the STI2 shown in FIG. 6C). In some examples, the STI2 further passes through the reflection layer 221 and is in contact with the conducting layer 220. Usually, after the STI2 is formed in the laser 22 and the oxide aperture 224 is prepared, an insulation material is deposited in the STI2 and on the reflection layer 223 to form an insulation layer 228. Then a pattern of the positive electrode 227 is prepared at the insulation layer 228 through photoengraving and etching processes, and then the positive electrode 227 is prepared. The insulation layer 228 exists between the positive electrode 227 and the STI2, and the positive electrode 227 is in contact with the reflection layer 223. In addition, a part of the insulation layer 228 further exists in an area surrounded by the positive electrode 227, and a projection of this part of the insulation layer 228 on the active layer 222 covers a projection of the oxide aperture 224 on the active layer 222.

For example, as shown in FIG. 8, regardless of whether the STI2 passes through the reflection layer 223 and the active layer 222 or the STI2 passes through the reflection layer 223, the active layer 222, and the reflection layer 221, the negative electrode 226 in FIG. 8 may or may not be in contact with the reflection layer 221. For example, an insulation layer may be disposed between the reflection layer 221 and the negative electrode 226, so that the negative electrode 226 is not in contact with the reflection layer 221; or a predetermined spacing is controlled between the reflection layer 221 and the negative electrode 226 in an x-axis direction, so that the negative electrode 226 is not in contact with the reflection layer 221.

In the laser array 20, the laser 21 includes the reflection layer 211, the active layer 212, and the reflection layer 213 that are sequentially disposed in the epitaxial direction, and the oxide aperture 214 is provided in the reflection layer 213. When the laser array 20 receives a voltage or a current, the voltage or the current is transmitted to the laser 21, to energize the laser 21. Therefore, the active layer 212 of the laser 21 generates a first photon, and the first photon oscillates in the resonant cavity formed by the reflection layer 211 and the reflection layer 213. In this way, first laser light is generated and is output through the oxide aperture 214. The laser 22 includes the reflection layer 221, the active layer 222, and the reflection layer 223 that are sequentially disposed in the epitaxial direction, the oxide aperture 224 is provided in the reflection layer 223, the light blocking layer 229 is further disposed on the side, away from the active layer 222, of the reflection layer 223, and the projection of the light blocking layer 229 on the active layer 222 overlaps the projection of the oxide aperture 224 on the active layer 222. When the laser array 20 receives a voltage or a current, the voltage or the current may be transmitted to the laser 22, to energize the laser 22. Therefore, the active layer 222 of the laser 22 generates a second photon, and the second photon oscillates in the resonant cavity formed by the reflection layer 221 and the reflection layer 223, to generate second laser light. The second laser light is transmitted to the light blocking layer 229 through the oxide aperture 224. The light blocking layer 229 blocks an output of the second laser light, or the light blocking layer 229 outputs a part of the second laser light. Emitted laser light output by the laser array 20 is specifically the first laser light and the second laser light. When the laser 21 is connected in parallel to the laser 22 and the laser array 20 receives a constant voltage, a differential resistance of the laser 21 and the laser 22 that are connected in parallel is less than the differential resistance of the laser 21. When the laser 21 is connected in parallel to the laser 22 and the laser array 20 receives a constant current, optical power of the emitted laser light output by the laser array 20 changes. When the laser 21 is connected in series to the laser 22 and the laser array 20 receives a constant voltage, optical power of the emitted laser light output by the laser array 20 changes. That is, when the laser array includes the laser 22, a differential resistance of the laser array is adjustable, and the optical power of the emitted laser light that is output is adjustable.

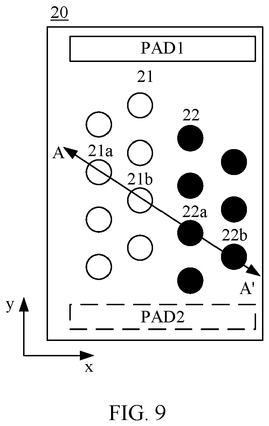

For example, as shown in FIG. 9, FIG. 12, FIG. 15, FIG. 16, and FIG. 19, the laser array 20 includes a plurality of lasers 21 and at least one laser 22, the plurality of lasers 21 are connected in parallel, and at least one laser 21 is electrically connected to any laser 22.

Specifically, refer to FIG. 9. A laser array 20 shown in FIG. 9 includes a plurality of lasers 21 and at least one laser 22, the plurality of lasers 21 are connected in parallel, at least one laser 21 is specifically connected in parallel to any laser 22, and a plurality of lasers 22 are connected in parallel. Specifically, the plurality of lasers 21 include a laser 21a and a laser 21b, and the plurality of lasers 22 include a laser 22a and a laser 22b. The laser 21a is connected in parallel to the laser 21b, the laser 22a is connected in parallel to the laser 22b, and the laser 21b is connected in parallel to the laser 22a.

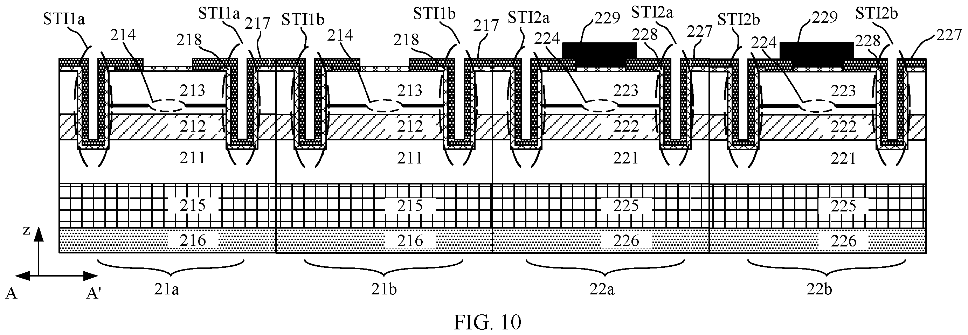

For example, FIG. 10 is a cross-sectional view of FIG. 9 along AA'. A structure of the laser 21 in FIG. 10 is shown in FIG. 6B, and a structure of the laser 22 in FIG. 10 is shown in FIG. 6C. The laser 21a is connected in parallel to the laser 21b, a positive electrode 217 of the laser 21a is connected to a positive electrode 217 of the laser 21b, and a negative electrode 216 of the laser 21a is connected to a negative electrode 216 of the laser 21b. The laser 22a is connected in parallel to the laser 22b. Specifically, a positive electrode 227 of the laser 22a is connected to a positive electrode 227 of the laser 22b, and a negative electrode 226 of the laser 22a is connected to a negative electrode 226 of the laser 22b. The laser 21b is connected in parallel to the laser 22a. Specifically, the positive electrode 217 of the laser 21b is connected to the positive electrode 227 of the laser 22a, and the negative electrode 216 of the laser 21b is connected to the negative electrode 226 of the laser 22a.

As shown in FIG. 10, preparation of the laser array 21 shown in FIG. 9 includes the following steps. Step 1: Sequentially epitaxially grow, on a substrate, a semiconductor material layer with a high refractive index that provides electrons, a semiconductor material layer with a high optical gain, and a semiconductor material layer with a high refractive index that provides electron holes. Step 2: Prepare, on the semiconductor material layer with a high refractive index that provides electron holes, an annular STI1a, an annular STI1b, an annular STI2a, and an annular STI2b through photoengraving and etching processes by using the semiconductor material layer with a high refractive index that provides electrons as an etching stop layer. An area surrounded by the STIla is the laser 21a, an area surrounded by the STIlb is the laser 21b, an area surrounded by the STI2a is the laser 22a, and an area surrounded by the STI2b is the laser 22b. A reflection layer 211 of the laser 21a, a reflection layer 211 of the laser 21b, a reflection layer 221 of the laser 22a, and a reflection layer 221 of the laser 22b are specifically the semiconductor material layer with a high refractive index that provides electrons. An active layer 212 of the laser 21a, an active layer 212 of the laser 21b, an active layer 212 of the laser 22a, and an active layer 212 of the laser 22b are specifically the semiconductor material layer with a high optical gain. A reflection layer 213 of the laser 21a, a reflection layer 213 of the laser 21b, a reflection layer 223 of the laser 22a, and a reflection layer 223 of the laser 22b are specifically the semiconductor material layer that provides electron holes.

Step 3: Grow an oxide inward from an inner wall of the STI. Specifically, an oxide grows inward from an inner wall of the annular STIla to form an oxide aperture 214 of the laser 21a, an oxide grows inward from an inner wall of the annular STI1b to form an oxide aperture 214 of the laser 21b, an oxide grows inward from an inner wall of the annular STI2a to form an oxide aperture 224 of the laser 22a, and an oxide grows inward from an inner wall of the annular STI2b to form an oxide aperture 224 of the laser 22b.

Step 4: Deposit an insulation material in the STI and on the semiconductor material layer that provides electron holes, to prepare an insulation layer 218 of the laser 21a, an insulation layer 218 of the laser 21b, an insulation layer 228 of the laser 22a, and an insulation layer 228 of the laser 22b.

Step 5: Deposit a conductive material on the semiconductor material with a high refractive index that provides electron holes, to prepare the positive electrode 217 of the laser 21a, the positive electrode 217 of the laser 21b, the positive electrode 227 of the laser 22a, and the positive electrode 227 of the laser 22b, and connect all the positive electrodes to a pin PAD1 of the laser array 20. Deposit a conductive material on a side, away from the semiconductor material with a high refractive index that provides electron holes, of the substrate, to prepare the negative electrode 216 of the laser 21a, the negative electrode 216 of the laser 21b, the negative electrode 226 of the laser 22a, and the negative electrode 226 of the laser 22b, and connect all the negative electrodes to a pin PAD2 of the laser array 20. For example, FIG. 9 is specifically a top view of the laser array 20. When the laser 21 and the laser 22 in the laser array 20 are arranged in a layer structure shown in FIG. 10, the negative electrodes are below the z-axis direction, and the positive electrodes are above the z-axis direction. Therefore, in the top view shown in FIG. 9, usually, the pin PAD1 can be seen but the pin PAD2 cannot be seen, because the pin PAD2 is at the bottom. In FIG. 9, a dashed-line box indicates that the pin PAD2 exists.

Step 6: Prepare a light blocking layer 229 on each laser 22, where a projection of the light blocking layer 229 on the active layer 222 overlaps a projection of the oxide aperture 224 on the active layer 222.

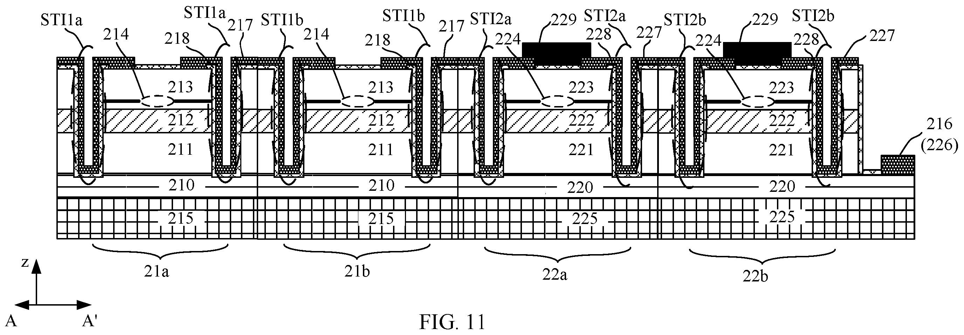

For example, FIG. 11 is a cross-sectional view of FIG. 9 along AA'. A structure of the laser 21 in FIG. 11 is shown in FIG. 7, and a structure of the laser 22 in FIG. 11 is shown in FIG. 8. The laser 21a is connected in parallel to the laser 21b, a positive electrode 217 of the laser 21a is connected to a positive electrode 217 of the laser 21b, a conducting layer 210 of the laser 21a is in contact with a conducting layer 210 of the laser 21b, and a negative electrode 216 of the laser 21a and a negative electrode 216 of the laser 21b are a shared negative electrode. The laser 22a is connected in parallel to the laser 22b. Specifically, a positive electrode 227 of the laser 22a is connected to a positive electrode 227 of the laser 22b, a conducting layer 220 of the laser 22a is in contact with a conducting layer 220 of the laser 22b, and a negative electrode 226 of the laser 22a and a negative electrode 226 of the laser 22b are a shared negative electrode. The laser 21b is connected in parallel to the laser 22a. Specifically, the positive electrode 217 of the laser 21b is connected to the positive electrode 227 of the laser 22a, the conducting layer 210 of the laser 21b is in contact with the conducting layer 220 of the laser 22a, and the negative electrode 216 of the laser 21b and the negative electrode 226 of the laser 22a are a shared negative electrode.

As shown in FIG. 11, preparation of the laser array 21 shown in FIG. 9 includes the following steps. Step 1: Sequentially epitaxially grow, on a substrate, a conductive semiconductor material layer, a semiconductor material layer with a high refractive index that provides electrons, a semiconductor material layer with a high optical gain, and a semiconductor material layer with a high refractive index that provides electron holes. For step 2, refer to step 2 shown in FIG. 10. However, in FIG. 11, an etching stop layer in step 2 is the conductive semiconductor material layer, and the conducting layer 210 of the laser 21a, the conducting layer 210 of the laser 21b, the conducting layer 220 of the laser 22a, and the conducting layer 220 of the laser 22b are specifically the conductive semiconductor material layer. For step 3, refer to step 3 shown in FIG. 10. For step 4, refer to step 4 shown in FIG. 10.

Step 5: Deposit a conductive material on the semiconductor material with a high refractive index that provides electron holes, to prepare the positive electrode 217 of the laser 21a, the positive electrode 217 of the laser 21b, the positive electrode 227 of the laser 22a, and the positive electrode 227 of the laser 22b, and connect all the positive electrodes to a pin PAD1 of the laser array 20. Deposit a conductive material on the conductive semiconductor material layer, to prepare the negative electrode 216 of the laser 21a, the negative electrode 216 of the laser 21b, the negative electrode 226 of the laser 22a, and the negative electrode 226 of the laser 22b, where all the negative electrodes are a shared negative electrode, and connect all the negative electrodes to a pin PAD2 of the laser array 20. The shared negative electrode is in contact with or not in contact with the semiconductor material with a high refractive index that provides electrons. FIG. 11 is specifically drawn by using an example in which the shared negative electrode is not in contact with the semiconductor material with a high refractive index that provides electrons. An insulation layer is disposed between the shared negative electrode and the semiconductor material with a high refractive index that provides electrons. For example, FIG. 9 is specifically a top view of the laser array 20. When the laser 21 and the laser 22 in the laser array 20 are arranged in a layer structure shown in FIG. 11, the pin PAD1 and the pin PAD2 can be seen in the top view shown in FIG. 9.

For step 6, refer to step 6 shown in FIG. 10.

For example, as shown in FIG. 10 and FIG. 11, when the laser array 20 is grounded through the pin PAD2 and receives a fixed voltage or a fixed current through the pin PAD1, the laser 21a, the laser 21b, the laser 22a, and the laser 22b may operate in parallel.

For example, the laser array 20 shown in FIG. 9 specifically includes M lasers 21 and N lasers 22, where M is a positive integer greater than or equal to 2, and N is a positive integer greater than or equal to 1. Differential resistances of the laser 21 and the laser 22 are approximately equal and are denoted as *Rₛ.* FIG. 9, a differential resistance of the laser array 20 is as follows: *R = Rₛ* /(*M + N*) (a formula 1). It can be learned from the formula 1 that the differential resistance of the laser array 20 decreases when a quantity of N increases.

For example, the laser array 20 may be disposed in the partition A2 in the laser array 11 shown in FIG. 2, to reduce a differential resistance that occurs when the partition A2 of the laser array 11 outputs emitted laser light. Alternatively, the laser array 20 is disposed in the partition A3 in the laser array 11 shown in FIG. 4, to reduce a differential resistance that occurs when the partition A3 of the laser array 11 outputs emitted laser light.

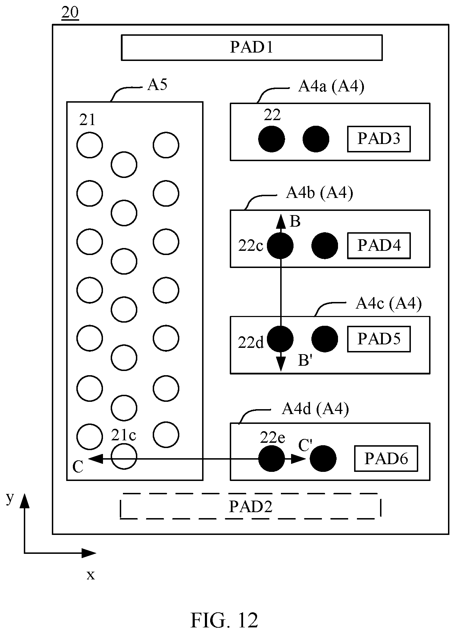

For example, refer to a laser array 20 shown in FIG. 12. The laser array 20 includes one or more areas A4 (also referred to as a first area). FIG. 12 specifically shows four areas A4: an area A4a, an area A4b, an area A4c, and an area A4d. The area A4 includes a laser 22. For example, the area A4 may include one laser 22; or the area A4 may include a plurality of lasers 22, and the plurality of lasers 22 included in the area A4 are connected in parallel.

At least one laser 21 in the laser array 20 is connected in parallel to the laser 22 in the area A4, and lasers 22 in any two areas A4 are connected in parallel. When the laser array 20 includes a plurality of areas A4, at least one laser 21 in the laser array 20 is connected in parallel to a laser 22 in each area A4, and lasers 22 in any two areas A4 are connected in parallel. Therefore, this may also be referred to as that each laser 21 in the laser array 20 is connected in parallel to a laser 22 in each area A4.

Lasers 22 in any two areas A4 are electrically isolated. Specifically, negative electrodes 216 of a plurality of lasers 21 shown in FIG. 12 are electrically connected to a pin PAD2, and positive electrodes 217 of the plurality of lasers 21 are electrically connected to a pin PAD1. In addition, in FIG. 12, each area A4 includes two lasers 22 connected in parallel, a negative electrode 226 of a laser 22 in each area A4 is also electrically connected to the pin PAD2, a positive electrode 227 of a laser 22 in each area A4 is not electrically connected to the pin PAD1, and positive electrodes 227 of lasers 22 in any two areas A4 are not connected. Positive electrodes 227 of two lasers 22 in the area A4a are electrically connected to a pin PAD3 of the laser array 20. Positive electrodes 227 of two lasers 22 in the area A4b are electrically connected to a pin PAD4 of the laser array 20. Positive electrodes 227 of two lasers 22 in the area A4c are electrically connected to a pin PAD5 of the laser array 20. Positive electrodes 227 of two lasers 22 in the area A4d are electrically connected to a pin PAD6 of the laser array 20.

For example, in the laser array 20 shown in FIG. 12, when the laser array 20 is grounded through the pin PAD2 and receives a fixed voltage or a fixed current through the pin PAD1 and the pin PAD3, the lasers 21 and the lasers 22 in the area A4a may operate in parallel, and lasers 22 in other areas A4 do not operate. In the laser array 20 shown in FIG. 12, when the laser array 20 is grounded through the pin PAD2 and receives a fixed voltage or a fixed current through the pin PAD1, the pin PAD3, and the pin PAD4, the lasers 21, the lasers 22 in the area A4a, and the lasers 22 in the area A4b may operate in parallel, and lasers 22 in other areas A4 do not operate.

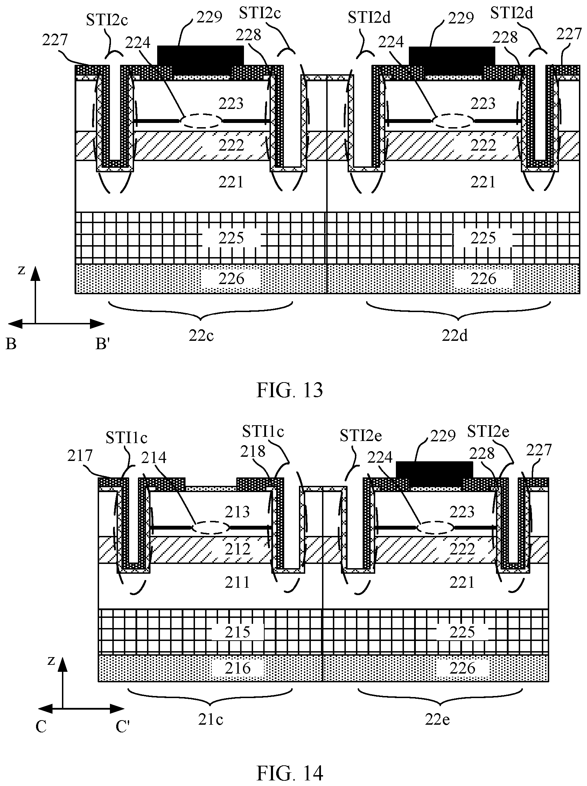

More specifically, FIG. 13 is a cross-sectional view of the laser array shown in FIG. 12 along BB'. The area A4b includes a laser 22c, and the area A4c includes a laser 22d. In FIG. 13, an area surrounded by an STI2c is specifically the laser 22c, and an area surrounded by an STI2d is specifically the laser 22d. Lasers 22 in any two areas A4 are electrically isolated. To be specific, the laser 22c is electrically isolated from the laser 22d. Specifically, as shown in FIG. 13, a negative electrode 226 of the laser 22c is connected to a negative electrode 226 of the laser 22d, but a positive electrode 227 of the laser 22c is not connected to a positive electrode 227 of the laser 22d, so that the laser 22c is electrically isolated from the laser 22d.

A structure of the laser 22 in FIG. 13 is shown in FIG. 6C. In some other embodiments, a structure of the laser 22 in FIG. 13 may be shown in FIG. 8. In this case, conducting layers 220 of two lasers 22 are in contact, negative electrodes 226 of the two lasers 22 are a shared negative electrode, and positive electrodes 227 of the two lasers 22 are not connected, so that the two lasers 22 are electrically isolated.

In the laser array 20 shown in FIG. 12, the laser array 20 includes one or more areas A4, the area A4 includes a laser 22, at least one laser 21 in the laser array 20 is connected in parallel to the laser 22 in the area A4, and lasers 22 in any two areas A4 are electrically isolated. The laser array 20 receives a fixed voltage. It is assumed that the laser array 20 includes M lasers 21 and X areas A4, and one area A4 includes Y lasers 22, where X is a positive integer greater than or equal to 1, and Y is a positive integer greater than or equal to 1. Because the at least one laser 21 is connected in parallel to the laser 22 in the area A4, when the laser array 20 receives a fixed voltage and all lasers are operating, optical power of laser light output by the plurality of lasers 21 does not change, and a differential resistance of the laser array 20 is as follows: *R = Rₛ* / (*M + X* × *Y*) (a formula 2). It can be learned from the formula 2 that the differential resistance of the laser array 20 decreases when X increases and/or Y increases, and the differential resistance of the laser array 20 increases when X decreases and/or Y decreases.

When the laser array 20 shown in FIG. 12 receives a fixed current *I*₀ and all the lasers are operating, because the plurality of lasers 21 are connected in parallel, the at least one laser 21 is connected in parallel to the laser 22 in the area A4, and the plurality of lasers 22 are connected in parallel, a current flowing through the M lasers 21 is as follows: *I = M* ×*I*₀ / (*M + X* ×*Y*) (a formula 3). Based on a relationship between power and a current, it can be learned that Δ*P* = Δ*I* × *SE* (a formula 4). In the formula 4, *SE* is slope efficiency, Δ*I* is a variation of the current flowing through the M lasers 21, and Δ*P* is a variation of optical power output by the M lasers 21 in parallel. It can be learned from the formula 3 and the formula 4 that, when X increases and/or Y increases, the current *I* flowing through the M lasers 21 decreases, and therefore optical power of laser light output by the M lasers 21 in the laser array 20 decreases; and when X decreases and/or Y decreases, the current *I* flowing through the M lasers 21 increases, and therefore optical power of laser light output by the M lasers 21 in the laser array 20 increases.

For example, in the laser array 20 shown in FIG. 12, the laser array 20 further includes an area A5, the area A5 includes a plurality of lasers 21, the plurality of lasers 21 are connected in parallel, and the laser 21 in the area A5 is electrically isolated from a laser 22 in any area A4.

For example, FIG. 14 is a cross-sectional view of FIG. 12 along CC'. The area A5 includes a laser 21c, and the area A4d includes a laser 22e. In FIG. 14, an area surrounded by an STIlc is specifically the laser 21c, and an area surrounded by an STI2e is specifically the laser 22e. As shown in FIG. 11, although a negative electrode 216 of the laser 21c is connected to a negative electrode 226 of the laser 22e, a positive electrode 217 of the laser 21c is not connected to a positive electrode 227 of the laser 22e, so that the laser 21c is electrically isolated from the laser 22e. Similarly, when a positive electrode 217 of any laser 21 in the area A5 is not connected to a positive electrode 227 of any laser 22 in the area A4, the laser 21 in the area A5 can be electrically isolated from a laser 22 in any area A4. Negative electrodes 216 of the plurality of lasers 21 in the area A5 are electrically connected to the pin PAD2 of the laser array 20, positive electrodes 217 of the plurality of lasers 21 in the area A5 are electrically connected to the pin PAD 1 of the laser array 20, and a positive electrode 227 of a laser 22 in any area A4 is not electrically connected to the pin PAD1 of the laser array 20.

A structure of the laser 21 in FIG. 14 is shown in FIG. 6B, and a structure of the laser 22 in FIG. 14 is shown in FIG. 6C. In some other embodiments, a structure of the laser 21 in FIG. 14 may be shown in FIG. 7, and a structure of the laser 22 in FIG. 14 may be shown in FIG. 8. In this case, a conducting layer 210 of the laser 21 is in contact with a conducting layer 220 of the laser 22, a negative electrode 216 of the laser 21 and a negative electrode 226 of the laser 22 are a shared negative electrode, and a positive electrode 217 of the laser 21 is not connected to a positive electrode 227 of the laser 22, so that the two lasers 22 are electrically isolated.

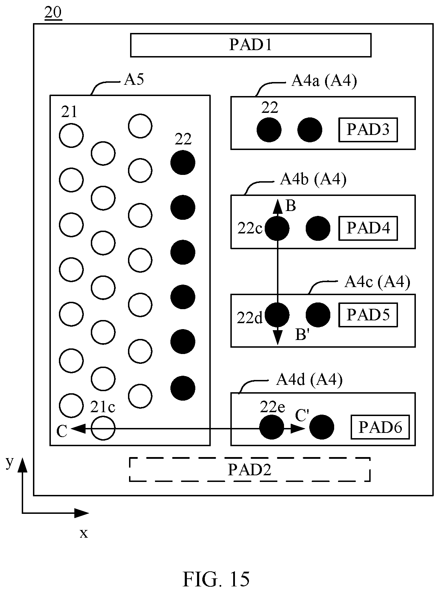

In some other embodiments, refer to FIG. 15. In comparison with the laser array 20 shown in FIG. 12, an area A5 in a laser array 20 shown in FIG. 15 further includes one or more lasers 22, and a laser 21 and the laser 22 in the area A5 are connected in parallel.

In the laser array 20 shown in FIG. 15, it is assumed that the laser array 20 includes X areas A4, one area A4 includes Y lasers 22, the laser array 20 further includes the area A5, and the area A5 includes M lasers 21 and N lasers 22. Differential resistances of the laser 21 and the laser 22 are approximately equal and are denoted as *Rₛ.*

When the laser array 20 shown in FIG. 15 receives a fixed voltage and all lasers are operating, because at least one laser 21 is connected in parallel to a laser 22 in an area A4, optical power of laser light output by a plurality of lasers 21 does not change, and a differential resistance of the laser array 20 is as follows: *R = Rₛ* /(*M + N + X* × *Y*) (a formula 5). It can be learned from the formula 5 that the differential resistance of the laser array 20 decreases when X increases and/or Y increases, and the differential resistance of the laser array 20 increases when X decreases and/or Y decreases.

When the laser array 20 shown in FIG. 15 receives a fixed current *I*₀, because the laser 21 and the laser 22 in the area A5 are connected in parallel, the at least one laser 21 in the area A5 is connected in parallel to the laser 22 in the area A4, and a plurality of lasers 22 are connected in parallel, a current flowing through the M lasers 21 is as follows: *I =* (*M + N*) × *I*₀ / (*M + N + X* × *Y*) (a formula 6). It can be learned from the formula 6 and the formula 4 that, when X increases and/or Y increases, the current *I* flowing through the M lasers 21 decreases, and therefore optical power of emitted laser light output by the M lasers 21 in the laser array 20 decreases; and when X decreases and/or Y decreases, the current *I* flowing through the M lasers 21 increases, and therefore optical power of emitted laser light output by the M lasers 21 in the laser array 20 increases.

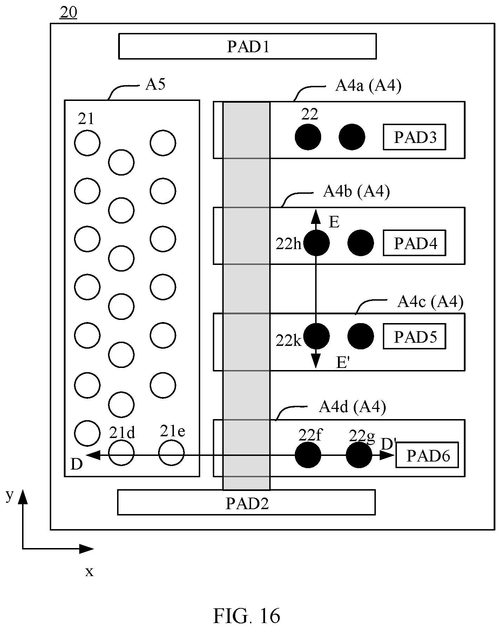

In some other embodiments, refer to a laser array 20 shown in FIG. 16. The laser array 20 includes one or more areas A4. FIG. 16 specifically shows four areas A4: an area A4a, an area A4b, an area A4c, and an area A4d. The area A4 includes a laser 22. For example, the area A4 may include one laser 22; or the area A4 may include a plurality of lasers 22, and the plurality of lasers 22 included in the area A4 are connected in parallel.

At least one laser 21 in the laser array 20 is connected in series to the laser 22 in the area A4, lasers 22 in any two areas A4 are electrically isolated, and lasers 22 in any two areas A4 are connected in parallel. Specifically, as shown in FIG. 16, negative electrodes 216 of a plurality of lasers 21 are electrically connected to a pin PAD2, and positive electrodes 217 of the plurality of lasers 21 are electrically connected to a pin PAD1. In addition, in FIG. 16, each area A4 includes two lasers 22 connected in parallel, a positive electrode 227 of a laser 22 in each area A4 is also electrically connected to the pin PAD2 (as indicated by a gray box in FIG. 16), a negative electrode 226 of a laser 22 in each area A4 is not electrically connected to the pin PAD1 or PAD2, and negative electrodes 226 of lasers 22 in any two areas A4 are not connected. Negative electrodes 226 of two lasers 22 in the area A4a are electrically connected to a pin PAD3 of the laser array 20. Negative electrodes 226 of two lasers 22 in the area A4b are electrically connected to a pin PAD4 of the laser array 20. Negative electrodes 226 of two lasers 22 in the area A4c are electrically connected to a pin PAD5 of the laser array 20. Negative electrodes 226 of two lasers 22 in the area A4d are electrically connected to a pin PAD6 of the laser array 20.

For example, in the laser array 20 shown in FIG. 16, when the laser array 20 receives a fixed voltage or a fixed current through the pin PAD1 and is grounded through the pin PAD3, the lasers 21 may operate in parallel, the lasers 22 in the area A4a operate in parallel, the parallel lasers 21 and the parallel lasers 22 operate in series, and lasers 22 in other areas A4 do not operate. In the laser array 20 shown in FIG. 16, when the laser array 20 receives a fixed voltage or a fixed current through the pin PAD1 and is grounded through the pin PAD3 and the pin PAD4, the lasers 21 may operate in parallel, the lasers 22 in the area A4a and the lasers 22 in the area A4a operate in parallel, the parallel lasers 21 and the parallel lasers 22 operate in series, and lasers 22 in other areas do not operate.

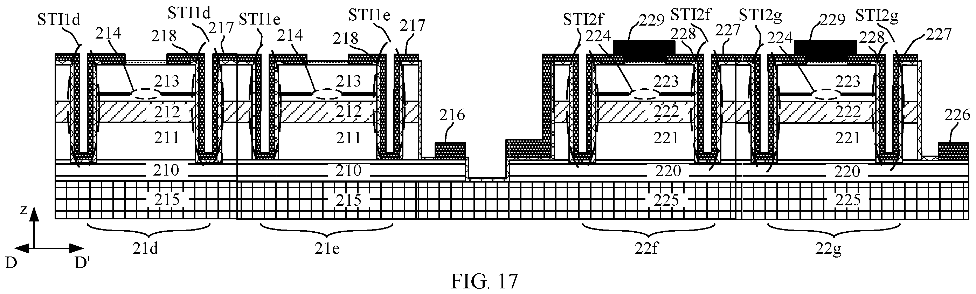

More specifically, FIG. 17 is a cross-sectional view of the laser array 20 shown in FIG. 16 along DD'. The area A4d includes a laser 22f and a laser 22g, and the laser array 20 further includes a laser 21d and a laser 21e. In FIG. 17, an area surrounded by an STIld is specifically the laser 21d, an area surrounded by an STI1e is specifically the laser 21e, an area surrounded by an STI2f is specifically the laser 22f, and an area surrounded by an STI2g is specifically the laser 22g. The laser 21d is connected in parallel to the laser 21e, a positive electrode 217 of the laser 21d is connected to a positive electrode 217 of the laser 21e, a conducting layer 210 of the laser 21d is in contact with a conducting layer 210 of the laser 21e, and a negative electrode 216 of the laser 21d and a negative electrode 216 of the laser 21e are a shared negative electrode. The laser 22f is connected in parallel to the laser 22g. Specifically, a positive electrode 227 of the laser 22f is connected to a positive electrode 227 of the laser 22g, a conducting layer 220 of the laser 22f is in contact with a conducting layer 220 of the laser 22g, and a negative electrode 226 of the laser 22f and a negative electrode 226 of the laser 22g are a shared negative electrode. The laser 21 is connected in series to the laser 22 in the area A4d. Specifically, the negative electrode 216 of the laser 21e is electrically connected to the positive electrode 227 of the laser 22f, and the conducting layer 210 of the laser 21e is not in contact with the conducting layer 220 of the laser 22f.

For example, when the laser 22f and the laser 22g shown in FIG. 17 are replaced with the laser 22 in the area A4a, the area A4b, or the area A4c, a cross-sectional view in a direction parallel to an x-axis is similar to that in FIG. 17.

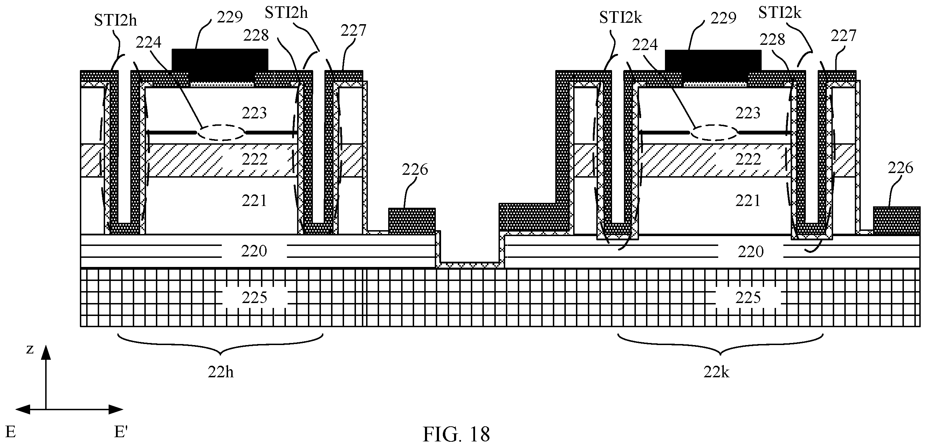

More specifically, FIG. 18 is a cross-sectional view of the laser array 20 shown in FIG. 16 along EE'. The area A4b includes a laser 22h, and the area A4c includes a laser 22k. In FIG. 18, an area surrounded by an STI2h is specifically the laser 22h, and an area surrounded by an STI2k is specifically the laser 22k. Lasers 22 in any two areas A4 are electrically isolated. To be specific, the laser 22h is electrically isolated from the laser 22k. Specifically, as shown in FIG. 18, a conducting layer 220 of the laser 22h is not in contact with a conducting layer 220 of the laser 22k, and there is an insulation part between the conducting layer 220 of the laser 22h and the conducting layer 220 of the laser 22k. In addition, in FIG. 18, a negative electrode 226 of the laser 22h is not connected to a negative electrode 226 of the laser 22k, the negative electrode 226 of the laser 22h is not connected to a positive electrode 227 of the laser 22k, and a positive electrode 227 of the laser 22h is not in contact with the positive electrode 227 of the laser 22k, so that the laser 22h is electrically isolated from the laser 22k. In addition, the positive electrode 227 of the laser 22h and the positive electrode 227 of the laser 22k are connected to the pin PAD2, so that the laser 21 is connected in series to the laser 22 in the area A4d.

In the laser array 20 shown in FIG. 16, the laser array 20 includes one or more areas A4, the area A4 includes a laser 22, at least one laser 21 in the laser array 20 is connected in series to the laser 22 in the area A4, lasers 22 in any two areas A4 are electrically isolated, and lasers 22 in any two areas A4 are connected in parallel. It is assumed that the laser array 20 includes M lasers 21 and X areas A4, and one area A4 includes Y lasers 22. Differential resistances of the laser 21 and the laser 22 are approximately equal and are denoted as *Rₛ.* receives a fixed current and all lasers are operating, because the laser 21 is connected in series to the laser 22 in the area A4, a plurality of lasers 21 are connected in parallel, and lasers 22 in any two areas A4 are connected in parallel, optical power of laser light output by the laser 21 does not change, and a differential resistance of the laser array 20 is as follows: *R = Rₛ* / *M + Rₛ* /(*X* × *Y)* (a formula 7). It can be learned from the formula 7 that the differential resistance of the laser array 20 decreases when X increases and/or Y increases, and the differential resistance of the laser array 20 increases when X decreases and/or Y decreases.

When the laser array 20 shown in FIG. 16 receives a fixed voltage *V*₀ and all the lasers are operating, because the laser 21 is connected in series to the laser 22 in the area A4, the plurality of lasers 21 are connected in parallel, and lasers 22 in any two areas A4 are connected in parallel, a voltage distributed to the M lasers 21 is as follows: *V =* (*X* × *Y*) × *V₀* /(*M + X* ×*Y*) (a formula 8). Based on a relationship between a voltage and a current, it can be learned that Δ*V* = Δ*I* * *Rₛ* / *M* (a formula 9), where Δ*V* is a variation of a voltage distributed to the plurality of lasers 21 connected in parallel, and Δ*I* is a variation of a current flowing through the M lasers 21. Based on the formula 9 and the formula 4, through division between parts on the left of equal signs and division between parts on the right of the equal signs, the following can be obtained: Δ*P =* Δ*V* × *SE* × *M*/*Rₛ* (a formula 10). It can be learned from the formula 10 that, when X increases and/or Y increases, optical power of emitted laser light output by the M lasers 21 in the laser array 20 increases; and when X decreases and/or Y decreases, optical power of emitted laser light output by the M lasers 21 in the laser array 20 decreases.

For example, the laser array 20 shown in FIG. 16 further includes an area A5, the area A5 includes a plurality of lasers 21, the plurality of lasers 21 are connected in parallel, and the laser 21 in the area A5 is electrically isolated from a laser 22 in any area A4. When the laser array 20 receives a fixed voltage or a fixed current through the pin PAD1 and is grounded through the pin PAD2, the lasers 21 may operate in parallel, and none of lasers 22 operates.

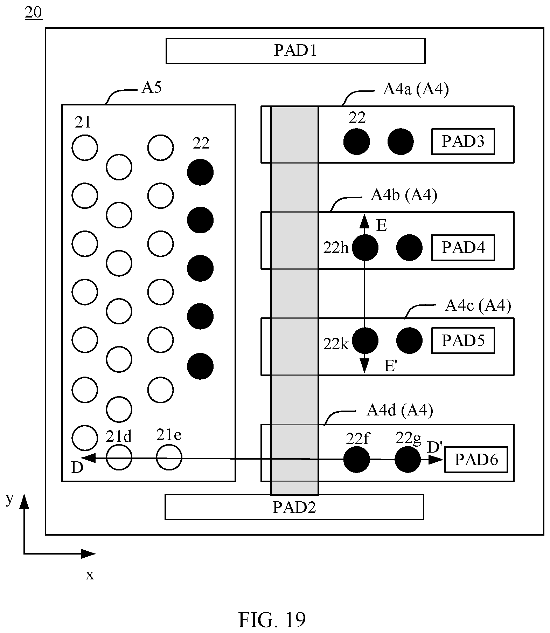

In some other embodiments, refer to FIG. 19. In comparison with the laser array 20 shown in FIG. 16, an area A5 in a laser array 20 shown in FIG. 19 further includes one or more lasers 22, and a laser 21 and the laser 22 in the area A5 are connected in parallel.

In the laser array 20 shown in FIG. 19, the laser array 20 includes one or more areas A4, the area A4 includes a laser 22, at least one laser 21 in the laser array 20 is connected in series to the laser 22 in the area A4, lasers 22 in any two areas A4 are electrically isolated, and lasers 22 in any two areas A4 are connected in parallel. The laser array 20 further includes the area A5, the area A5 includes a plurality of lasers 21 and the one or more lasers 22, and the laser 21 and the laser 22 in the area A5 are connected in parallel. It is assumed that the laser array 20 includes X areas A4, one area A4 includes Y lasers 22, and the area A5 includes M lasers 21 and N lasers 22. Differential resistances of the laser 21 and the laser 22 are approximately equal and are denoted as *Rₛ.*

When the laser array 20 shown in FIG. 19 receives a fixed current and all lasers are operating, because the laser 21 is connected in series to the laser 22 in the area A4, the plurality of lasers 21 are connected in parallel, and lasers 22 in any two areas A4 are connected in parallel, optical power of laser light output by the laser 21 does not change, and a differential resistance of the laser array 20 is as follows: *R = Rₛ* /(*M + N*) *+ Rₛ* / (*X*×*Y*) (a formula 11). It can be learned from the formula 11 that the differential resistance of the laser array 20 decreases when X increases and/or Y increases, and the differential resistance of the laser array 20 increases when X decreases and/or Y decreases.

When the laser array 20 shown in FIG. 19 receives a fixed voltage *V*₀ and all the lasers are operating, because the laser 21 is connected in series to the laser 22 in the area A4, the plurality of lasers 21 are connected in parallel, and lasers 22 in any two areas A4 are connected in parallel, a voltage distributed to the M lasers 21 is as follows: *V =* (*X* × *Y*) × *V*₀ /(*M + N+ X* × *Y*) (a formula 12). Based on a relationship between a voltage and a current, it can be learned that Δ*V =* Δ*I*Rₛ* / (*M+N*) (a formula 13), where Δ*V* is a variation of a voltage distributed to the plurality of lasers 21 connected in parallel, and Δ*I* is a variation of a current flowing through the M lasers 21. Based on the formula 13 and the formula 4, through division between parts on the left of equal signs and division between parts on the right of the equal signs, the following can be obtained: Δ*P* = ΔV×*SE*×(*M+N*) / *Rₛ* (a formula 14). It can be learned from the formula 14 that, when X increases and/or Y increases, optical power of emitted laser light output by the M lasers 21 in the laser array 20 increases; and when X decreases and/or Y decreases, optical power of emitted laser light output by the M lasers 21 in the laser array 20 decreases.

For example, in the laser array 20 shown in FIG. 9, FIG. 12, FIG. 15, FIG. 16, or FIG. 19, it is assumed that the laser 22 does not output laser light during operation. Therefore, optical power of emitted laser light output by the laser array 20 is optical power of laser light output by the laser 21 in the laser array 20.

For example, the laser array 20 shown in FIG. 9, FIG. 12, FIG. 15, FIG. 16, or FIG. 19 may be disposed in the lidar 10 shown in FIG. 1. In this case, the driving apparatus 12 is configured to input a fixed voltage or a fixed current to the laser array 20 shown in FIG. 9, FIG. 12, FIG. 15, FIG. 16, or FIG. 19.

For example, when the driving apparatus 12 inputs a fixed voltage to the laser array 20 shown in FIG. 9, a quantity of lasers 22 in the laser array 20 is negatively correlated with a differential resistance of the laser array 20.

For example, the laser array 20 shown in FIG. 12, FIG. 15, FIG. 16, or FIG. 19 includes one or more areas A4. The driving apparatus 12 may input a fixed voltage or a fixed current to n areas A4, so that lasers 22 in the n areas A4 operate together with the laser 21, where n is a positive integer greater than or equal to 0.

For example, when the driving apparatus 12 inputs a fixed voltage to the laser array 20 shown in FIG. 12 or FIG. 15, it is assumed that the driving apparatus 12 may input a fixed voltage to n areas A4, where n is negatively correlated with a differential resistance of the laser array 20. When the driving apparatus 12 inputs a fixed current to the laser array 20 shown in FIG. 12 or FIG. 15, it is assumed that the driving apparatus 12 may input a fixed voltage to n areas A4, where n is negatively correlated with optical power output by the laser 21 in the laser array 20.

For example, when the driving apparatus 12 inputs a fixed current to the laser array 20 shown in FIG. 16 or FIG. 19, it is assumed that the driving apparatus 12 may input a fixed voltage to n areas A4, where n is negatively correlated with a differential resistance of the laser array 20. When the driving apparatus 12 inputs a fixed voltage to the laser array 20 shown in FIG. 16 or FIG. 19, it is assumed that the driving apparatus 12 may input a fixed voltage to n areas A4, where n is positively correlated with optical power output by the laser 21 in the laser array 20.

In some examples, the driving apparatus 12 is configured to receive an input signal, and control, based on the input signal, an input of a fixed voltage or a fixed current to n areas A4, where the input signal is an input signal received by the lidar 10. For example, a designer of the lidar determines, based on a parameter of the lidar 10 and the distance between the obstacle and the lidar 10, to select n areas A4 for operation. In this case, the lidar 10 receives an input signal input by the designer, where the input signal indicates a quantity n of selected areas A4, and the input signal is transmitted to the driving apparatus 12, so that the driving apparatus 12 inputs a fixed voltage or a fixed current to the n areas A4 based on the input signal.

In some other examples, the driving apparatus 12 is configured to receive a feedback signal, and control, based on the feedback signal, an input of a fixed voltage or a fixed current to n areas A4. For example, the receiving apparatus 14 is configured to receive reflected laser light, generate a received signal, and transmit the received signal to the signal processing apparatus 13, where emitted laser light is reflected to form the reflected laser light when encountering the obstacle; and the signal processing apparatus 13 is configured to generate the feedback signal based on the received signal, where the feedback signal indicates a quantity n of selected areas A4. For example, when n is positively correlated with optical power output by the laser 21 in the laser array 20 and the received signal is greater than a predetermined value, to be specific, optical power of a received reflected signal is excessively high, the feedback signal generated by the signal processing apparatus 13 indicates to reduce the quantity n of selected areas A4. For example, when n is negatively correlated with optical power output by the laser 21 in the laser array 20 and the received signal is greater than a predetermined value, to be specific, optical power of a received reflected signal is excessively high, the feedback signal generated by the signal processing apparatus 13 indicates to increase the quantity n of selected areas A4.

Although this application is described with reference to specific features and embodiments thereof, it is clear that various modifications and combinations may be made to the features and embodiments without departing from the spirit and scope of this application. Correspondingly, this specification and the accompanying drawings are merely example descriptions of this application defined in the appended claims, and are considered as covering any and all modifications, variations, combinations or equivalents within the scope of this application. Clearly, a person skilled in the art can make various modifications and variations to this application without departing from the spirit and scope of this application. This application is intended to include these modifications and variations of this application provided that they fall within the scope of the claims of this application and their equivalent technologies.

## Claims

1. A laser array, wherein the laser array comprises a first laser and a second laser, wherein
the first laser comprises a first reflection layer, a first active layer, and a second reflection layer that are sequentially disposed in an epitaxial direction, and a first oxide aperture is provided in the second reflection layer;
the second laser comprises a third reflection layer, a second active layer, and a fourth reflection layer that are sequentially disposed in the epitaxial direction, a second oxide aperture is provided in the fourth reflection layer, a light blocking layer is further disposed on a side, away from the second active layer, of the fourth reflection layer, and a projection of the light blocking layer on the second active layer overlaps a projection of the second oxide aperture on the second active layer; and
the first laser is electrically connected to the second laser.

2. The laser array according to claim 1, wherein the laser array comprises a plurality of first lasers and at least one second laser;
the plurality of first lasers are connected in parallel; and
at least one first laser is electrically connected to any second laser.

3. The laser array according to claim 2, wherein the laser array comprises one or more first areas;
the first area comprises the second laser;
at least one first laser is connected in parallel to the second laser in the first area; and
the second lasers in any two first areas are electrically isolated, and the second lasers in any two first areas are connected in parallel.

4. The laser array according to claim 2, wherein the laser array comprises one or more first areas;
the first area comprises the second laser;
at least one first laser is connected in series to the second laser in the first area; and
the second lasers in any two first areas are electrically isolated, and the second lasers in any two first areas are connected in parallel.

5. The laser array according to claim 3 or 4, wherein the laser array further comprises a second area;
the second area comprises a plurality of first lasers; and
the first laser in the second area is electrically isolated from the second laser in any first area.

6. The laser array according to claim 5, wherein
one or more second lasers are further disposed in the second area, and the first laser and the second laser in the second area are connected in parallel.

7. The laser array according to any one of claims 3 to 6, wherein
the first area comprises a plurality of second lasers, and the plurality of second lasers are connected in parallel.

8. The laser array according to any one of claims 1 to 7, wherein
the laser array is configured to receive a fixed voltage.

9. The laser array according to any one of claims 1 to 7, wherein
the laser array is configured to receive a fixed current.

10. The laser array according to any one of claims 1 to 9, wherein
the first laser further comprises: a first substrate disposed on a side, away from the first active layer, of the first reflection layer, a first negative electrode disposed on a side, away from the first active layer, of the first substrate, and a first positive electrode disposed on a side, away from the first active layer, of the second reflection layer; or
the first laser further comprises: a first substrate disposed on a side, away from the first active layer, of the first reflection layer, a first conducting layer disposed between the first substrate and the first reflection layer, a first negative electrode in contact with the first conducting layer, and a first positive electrode disposed on a side, away from the first active layer, of the second reflection layer.

11. The laser array according to any one of claims 1 to 10, wherein
the second laser further comprises: a second substrate disposed on a side, away from the second active layer, of the third reflection layer, a second negative electrode disposed on a side, away from the second active layer, of the second substrate, and a second positive electrode disposed on a side, away from the second active layer, of the fourth reflection layer; or
the second laser further comprises: a second substrate disposed on a side, away from the second active layer, of the third reflection layer, a second conducting layer disposed between the second substrate and the third reflection layer, a second negative electrode in contact with the second conducting layer, and a second positive electrode disposed on a side, away from the second active layer, of the fourth reflection layer.

12. A lidar, comprising a driving apparatus and the laser array according to any one of claims 1 to 11, wherein
the driving apparatus is configured to input a fixed voltage or a fixed current to the laser array.

13. The lidar according to claim 12, wherein
the laser array comprises one or more first areas; and
the driving apparatus is configured to receive an input signal, and control, based on the input signal, an input of the fixed voltage or the fixed current to n first areas, wherein the input signal is an input signal received by the lidar, and n is an integer greater than or equal to 0.

14. The lidar according to claim 12, wherein
the laser array comprises one or more first areas; and
the driving apparatus is configured to receive a feedback signal, and control, based on the feedback signal, an input of the fixed voltage or the fixed current to n first areas, wherein n is an integer greater than or equal to 0.

15. The lidar according to claim 14, wherein
the lidar further comprises a receiving apparatus and a signal processing apparatus;
the receiving apparatus is configured to receive reflected laser light, generate a received signal, and transmit the received signal to the signal processing apparatus, wherein the emitted laser light is reflected to form the reflected laser light when encountering an obstacle; and
the signal processing apparatus is configured to generate the feedback signal based on the received signal.

16. The lidar according to claim 15, wherein
the signal processing apparatus is further configured to determine a distance between the obstacle and the lidar based on the received signal.
